# EUROPEAN PATENT SPECIFICATION

(11) **EP 3 893 617 B1**
(45) Date of publication and mention of the grant of the patent: **26.02.2025**
(21) Application number: 20741897.1
(22) Date of filing: 08.01.2020
(51) Int. Cl.: H05K 7/20, H04M 1/02, G06F 1/20, G06F 1/16, G06F 1/26

(54) **CHARGING SYSTEM, COOLING APPARATUS, AND CONTROL METHOD THEREFOR**
AUFLADESYSTEM, KÜHLVORRICHTUNG UND STEUERVERFAHREN DAFÜR
SYSTÈME DE CHARGE, APPAREIL DE REFROIDISSEMENT, ET SON PROCÉDÉ DE COMMANDE

(30) Priority: 17.01.2019 CN 201910043688
(43) Date of publication of application: 13.10.2021
(73) Proprietor: GUANGDONG OPPO MOBILE TELECOMMUNICATIONS CORP., LTD., Dongguan, Guangdong 523860 (CN)
(72) Inventor: YANG, Jun, Dongguan, Guangdong 523860 (CN)
(74) Representative: Ipside
(86) International application number: PCT/CN2020/070973
(87) International publication number: WO 2020/147629

(56) References cited:
- WO-A1-2018/019021
- CN-A- 102 833 387
- CN-A- 104 065 767
- CN-A- 105 764 305
- JP-A- 2007 265 800
- US-A1- 2012 202 373
- US-A1- 2018 288 898

## Description

### TECHNICAL FIELD

The present application relates to the field of charging technologies, and in particular to a charging system, a heat dissipation apparatus and a control method thereof.

### BACKGROUND

For most of the electronic devices in the related art, such as mobile phones, a heat dissipation apparatus may be provided inside the electronic device. The internal heat dissipation device may be configured for heat dissipation, but the heat dissipation effect may not be good, which may affect increase of a charging power.

The US patent application No. US 2018288898A1 discloses a first housing comprising a hollow portion configured to receive an external electronic device, and a second housing disposed at an angle defined by a portion coupled with at least part of the hollow portion. The second housing may include a first cover facing at least part of the hollow portion and comprising a plurality of first openings, a second cover received in the first cover and comprising a plurality of second openings, and an electric fan motor disposed in a space between the first cover and the second cover, the electric fan motor configured to discharge at least part of intake air from at least some of the first openings to at least some of the second openings.

### SUMMARY OF THE DISCLOSURE

According to the present disclosure, a heat dissipation apparatus, a charging system, and a control method for a heat dissipation apparatus are set out as the appended set of claims.

According to the present disclosure, a heat dissipation apparatus includes: a connection assembly, having a first connection port and a second connection port; a heat dissipation assembly; and a control unit, connected to the connection assembly and the heat dissipation assembly. The control unit is configured to obtain information sent by at least one of an electronic device and a charging device through the connection assembly in response to the first connection port being connected to the charging device and the second connection port being connected to the electronic device. The control unit is configured to control a heat dissipation process of the heat dissipation assembly based on the information sent by at least one of the electronic device and the charging device. In this way, the charging device may charge the electronic device through the heat dissipation apparatus. The charging device may communicate with the electronic device through the heat dissipation apparatus. Therefore, the heat dissipation apparatus may obtain information sent from at least one of the electronic device and the charging device.

### BRIEF DESCRIPTION OF THE DRAWINGS

The above and additional aspects and advantages of the present disclosure will become obvious and may be easily understood from the following description of the embodiments referring to the accompanying drawings.
FIG. 1 is a block diagram of a heat dissipation apparatus according to an embodiment of the present disclosure.
FIG. 2 is a block diagram of a heat dissipation device according to an embodiment of the present disclosure.
FIG. 3 is a block diagram of a charging system according to an embodiment of the present disclosure.
FIG. 4 is a flowchart of a control method of a heat dissipation apparatus according to an embodiment of the present disclosure.

### DETAILED DESCRIPTION

The embodiments of the present disclosure will be described in detail below. Examples of the embodiments are shown in the accompanying drawings. A same or similar reference numeral may indicate a same or similar element or element having a same or similar function. The embodiments described below with reference to the accompanying drawings may be exemplary, and intended to explain the present disclosure, but should not be interpreted as limitation to the present disclosure.

The charging system, the heat dissipation apparatus and the control method of the heat dissipation apparatus will be described in the embodiments of the present disclosure hereinafter with reference to the drawings.

It should be noted that in the embodiments of the present disclosure, the heat dissipation apparatus may be configured to dissipate heat, for example, to dissipate heat for an electronic device. Specifically, when the charging device charges a battery, for example, charges the battery in a large power, the heat dissipation apparatus may facilitate the electronic device to dissipate the heat generated while charging, such that temperature of the electronic device may be reduced. While the electronic device is in use, the heat dissipation apparatus may also dissipate heat for the electronic device.

It should be understood that the electronic device, which is configured with an external heat dissipation apparatus for heat dissipation, may be charged in a high power, such as being charged through wires at 60W, 70W, 80W, 90W, 100W, and so on. For the electronic device in the art without the heat dissipation apparatus, a power of wired charging may reach up to 50W.

A charging device may be configured to charge the battery in the electronic device. The electronic device may refer to a mobile terminal. The "mobile terminal" may include, but may not be limited to, a smart phone, a computer, a personal digital assistant (PDA), a wearable device, a Bluetooth earphone, a gaming apparatus, a camera apparatus, and the like. The charging device may be, an adapter, a mobile power (rechargeable battery) or a vehicle charger and other device having a function of charging the terminal.

In the embodiments of the present disclosure, the charging device may be connected to a charging port of the electronic device through the heat dissipation apparatus. In this way, the charging device may charge the electronic device through the heat dissipation apparatus. The charging device may communicate with the electronic device through the heat dissipation apparatus. Therefore, the heat dissipation apparatus may obtain information sent from at least one of the electronic device and the charging device. For example, when the electronic device communicates with the charging device via the heat dissipation apparatus, the heat dissipation apparatus may monitor communication information between the charging device and the electronic device. The communication information may include information sent from the electronic device to the charging device and information sent from the charging device to the electronic device. In detail, the electronic device may report information, such as temperature, a charging parameter, and the like, to the charging device through the heat dissipation apparatus. When the heat dissipation apparatus monitors the communication information, the heat dissipation apparatus may control heat dissipation performance of the heat dissipation apparatus based on the monitored communication information. As another example, when the electronic device communicates with the charging device through the heat dissipation apparatus, the heat dissipation apparatus may receive information sent to the heat dissipation apparatus from at least one of the electronic device and the charging device. In detail, the electronic device or the charging device may send information, such as the temperature, the charging parameter, and the like, to the heat dissipation apparatus. When the heat dissipation apparatus receives the information, the heat dissipation apparatus may control the dissipation performance of the heat dissipation apparatus based on the received information.

Therefore, wired communicative connection between the heat dissipation apparatus and the electronic device and between the heat dissipation apparatus and the charging device may be achieved. Wired communication may be stable and inexpensive, and the heat dissipation performance of the heat dissipation apparatus may be adjusted in real time by monitoring the information of at least one of the charging device and the electronic device. A better heat dissipation effect may be achieved.

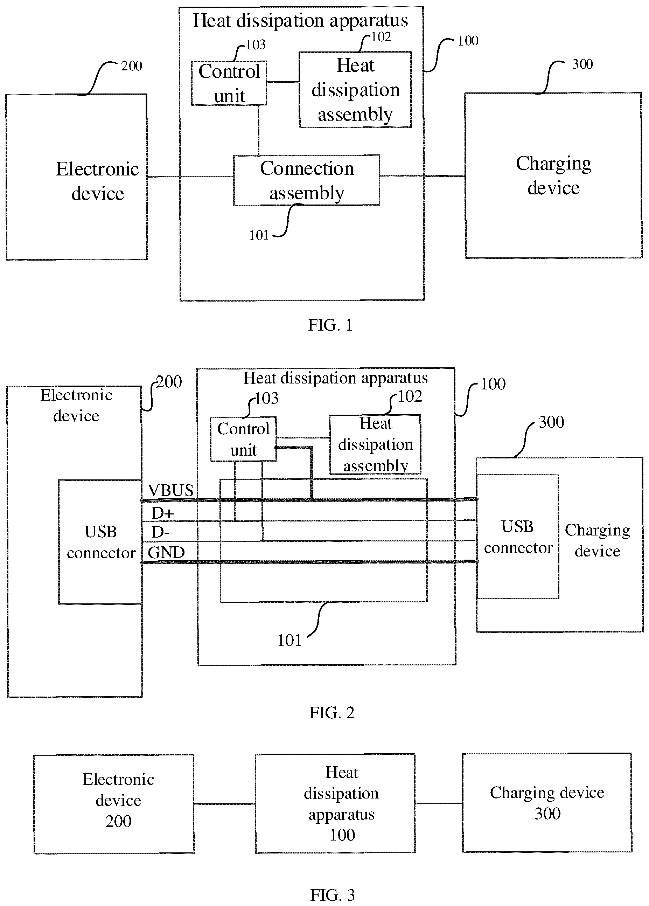

As shown in FIGS. 1 and 2, the heat dissipation apparatus according to the embodiments of the present disclosure may be described in detail.

FIG. 1 is a block diagram of a heat dissipation apparatus according to an embodiment of the present disclosure. As shown in FIG. 1, the heat dissipation apparatus 100 includes: a connection assembly 101, a heat dissipation assembly 102, and a control unit 103.

The connection assembly 101 has a first connection port and a second connection port. The first connection port of the connection assembly 101 may be connected to a charging device 300. The second connection port of the connection assembly 101 may be connected to an electronic device 200. As an example, the connection assembly 101 may be a Universal Serial Bus (USB) connector. The first connection port of the connection assembly 101 may be connected to a USB connector of the charging device 300 via a USB line. The second connection port of the connection assembly 101 may be plugged directly into a USB connector (i.e., a charging port) of the electronic device 200 or connected to the USB connector of the electronic device 200 via the USB line.

It should be understood that the charging device 300 may communicate with the electronic device 200 through the connection assembly 101. Of course, the charging device 300 may also communicate with the heat dissipation apparatus through the connection assembly 101. The electronic device 200 may also communicate with the heat dissipation apparatus through the connection assembly 101.

In detail, in some embodiments, when the charging device 300 is connected to the first connection port of the connection assembly 101, and when the electronic device 200 is connected to the second connection port of the connection assembly 101, wired communication between the electronic device 200 and the charging device 300 may be established through the connection assembly 101. That is, the electronic device 200 may send information, such as temperature, a charging parameter, and the like, to the charging device 300 through the connection assembly 101. The charging device 300 may send information to the electronic device 200 through the connection assembly 101. As the electronic device 200 and the charging device 300 communicate through the connection assembly 101, the heat dissipation apparatus 100 may obtain the information sent by the electronic device 200 and the information sent by the charging device 300 by detecting communication information between the electronic device 200 and the charging device 300.

In some other embodiments, when the charging device 300 is connected to the first connection port of the connection assembly 101, and when the electronic device 200 is connected to the second connection port of the connection assembly 101, the heat dissipation apparatus 100 may be connected to the charging device 300 and the electronic device 200 through wires, respectively, such that the heat dissipation apparatus 100 may communicate directly with at least one of the charging device 300 and the electronic device 200. That is, the heat dissipation apparatus 100 may send information to the charging device 300 or receive information from the charging device 300 via the connection assembly 101. Similarly, the heat dissipation apparatus 100 may send information to the electronic device 200 or receive information from the electronic device 200 via the connection assembly 101.

In this way, wired connection communication between charging device 300, electronic device 200 and heat dissipation apparatus 100 may be achieved, and the wired communication may be stable, fast and have low cost.

Further, the charging device 300 may also charge the electronic device 200 through the connection assembly 101. That is, when the charging device 300 is connected to the first connection port of the connection assembly 101, and the electronic device 200 is connected to the second connection port of the connection assembly 101, the charging device 300 may charge the battery of the electronic device 200 through the connection assembly 101. In detail, the electronic device 200 may be configured to collect a state parameter of the battery and send the state parameter of the battery to the charging device 300 through the connection component 101. The charging device 300 may determine a current charging parameter based on the state parameter of the battery, and may charge the battery based on the current charging parameter. Alternatively, the electronic device 200 may not only be configured to collect the state parameter of the battery, but also configured to determine the current charging parameter based on the state parameter of the battery. Further, the electronic device 200 may send the current charging parameter to the charging device 300 via the connection component 101, such that the charging device 300 may charge the battery based on the current charging parameter.

In an embodiment of the present disclosure, as shown in FIG. 2, the connection assembly 101 may include a power line. An end of the power line may be connected to the first connection port, and the other end of the power line may be connected to the second connection port. When the first connection port is connected to the charging device 300, and the second connection port is connected to the electronic device 200, the power line may transfer electrical energy output from the charging device 300 to the electronic device 200 to charge the electronic device 200. That is, the charging device 300 may charge the electronic device 200 via the power line.

In detail, the power line may include a positive power line VBUS and a negative power line GND. An end of the positive power cord VBUS and an end of the negative power cord GND may both be connected to the first connection port to further connect to the charging device 300 through the first connection port. The other end of the positive power cord VBUS and the other end of the negative power cord GND may both be connected to the second connection port to further connect to the electronic device 200 through the second connection port. For example, the charging device 300 may output a charging voltage that meets a charging demand. The charging voltage may be provided to a charging interface of the electronic device 200 via the positive power line VBUS and the negative power line GND. The charging interface of the electronic device 200 may load the charging voltage to the battery for charging.

As shown in FIG. 2, the connection assembly 101 may further include a data line. An end of the data line may be connected to the first connection port, and the other end of the data line may be connected to the second connection port. When the first connection port is connected to the charging device 300, and the second connection port is connected to the electronic device 200, the data line may transmit the information sent by the electronic device 200 to the charging device 300 and/or transmit the information sent by the charging device 300 to the electronic device 200. The control unit 103 obtains the information sent by at least one of the electronic device 200 and the charging device 300 through the data line.

In other words, the charging device 300 may communicate with the electronic device 200 via the data line, and data line may be connected to a communication end of the control unit 103. In detail, the data line may include a first data line D+ and a second data line D-. The first data line D+ and the second data line D- may be connected to the control unit 103, such as an MCU, of the heat dissipation apparatus 100. The control unit 103 may monitor information sent by the electronic device 200 and the charging device 300 by monitoring information on the first data line D+ and the second data line D-. For example, the control unit 103 may monitor in real time the information, which is sent by the electronic device 200 via the first data line D+, and the information, which is sent by the charging device 300 via the second data line D-. Alternatively, the control unit 103 receives the information, which is sent by the electronic device 200 to the heat dissipation apparatus 100 via the first data line D+, and the information, which is sent by the charging device 300 to the heat dissipation apparatus 100 via the second data line D-.

As shown in FIG. 2, the power line may be connected to a power supply end of the control unit 103 to supply power for the control unit 103. In detail, the power supply end of the control unit 103 may be connected to the power line in the connection assembly 101. When power is available on the power line, such as when the charging device 300 charges the battery of the electronic device 200, or when the battery of the electronic device 200 supplies power to the power line, the control unit 103 may draw power directly from the power line in the connection assembly 101. The heat dissipation assembly 102 may be configured to dissipate heat under the control of the control unit 103, for example, to dissipate heat from the electronic device. It should be understood that the heat dissipation assembly 102 may dissipate heat from the electronic device 200 while the charging device 300 is charging the battery of the electronic device 200. The heat dissipation assembly 102 may dissipate heat from the electronic device 200 while the electronic device 200 is in use. As an example, the heat dissipation assembly 101 may include at least one of a fan cooling assembly, a water circulation cooling assembly, a liquid nitrogen cooling assembly, a semiconductor cooling assembly, and a compressor cooling assembly. That is, the heat dissipation apparatus 100 has a cooling function. The heat dissipation apparatus 100 may dissipate heat from the electronic device 300 by any one of the fan cooling assembly, the water circulation cooling assembly, the liquid nitrogen cooling assembly, the semiconductor cooling assembly, and the compressor cooling assembly, or by a combination thereof.

In the embodiments of the present disclosure, the control unit 103 is connected to the connection assembly 101 and the heat dissipation assembly 102. When the first connection port is connected to the charging device, and the second connection port is connected to the electronic device, the control unit 103 obtains the information sent by at least one of the electronic device 200 and the charging device 300 through the connection assembly 101, and may control a heat dissipation process of the heat dissipation assembly 102 based on the information sent by at least one of the electronic device 200 and the charging device 300.

It should be noted that, controlling the heat dissipation process of the heat dissipation assembly may include: controlling the heat dissipation assembly to be turned on and off, controlling a heat dissipation power, and the like.

It should be understood that the charging device 300 may communicate with the electronic device 200 through the connection assembly 101. The control unit 103 may obtain the information sent by at least one of the electronic device 200 and the charging device 300 by directly monitoring the information on the data line of the connection assembly 101. The control unit 103 controls the heat dissipation process of the heat dissipation assembly 102 based on the information sent by at least one of the electronic device 200 and the charging device 300. Alternatively, both the charging device 300 and the electronic device 200 may communicate with the heat dissipation apparatus 100 through the connection assembly 101. The control unit 103 may receive the information sent by at least one of the electronic device 200 and the charging device 300 directly through the data line of the connection assembly 101. The control unit 103 may control the heat dissipation process of the heat dissipation assembly 102 based on the information sent by at least one of the electronic device 200 and charging device 300.

Therefore, the control unit 103 may intelligently control the heat dissipation of the heat dissipation apparatus by monitoring the information sent by at least one of the electronic device 200 and the charging device 300 in real time, and the heat dissipation effect may be improved effectively. In this way, the electronic device may be charged in a higher power, a charging rate may be maximized, charging efficiency may be improved, and charging time may be reduced.

According to an embodiment of the present disclosure, the control unit 103 may obtain state information of the electronic device through the connection assembly 101, and may adjust a heat dissipation power of the heat dissipation assembly 100 based on the state information of the electronic device.

As an example, when the charging is performed in the high power, the electronic device 200 may report the state information, such as the charging parameter and the temperature, to the charging device 300 through the first data line D+ and the second data line D-. The control unit 103 of the heat dissipation apparatus 100 may monitor the state information through the first data line D+ and the second data line D-, and control the heat dissipation power of the heat dissipation apparatus to increase or decrease based on the monitored information. Alternatively, when the charging is performed in the high power, the electronic device 200 may send the state information, such as the charging parameter and the temperature, and the like, to the heat dissipation apparatus via the first data line D+ and the second data line D-. The control unit 103 of the heat dissipation apparatus 100 may receive the information via the first data line D+ and the second data line D- and may control the heat dissipation power of the heat dissipation apparatus to increase or decrease based on the detected information.

Heat dissipation apparatus may be controlled intelligently, such that the heat dissipation performance may be optimized, the electronic device may be charged in a higher power, the charging rate and the charging efficiency may be maximized, and the charging time may be reduced.

According to an embodiment of the present disclosure, the state information of the electronic device may include the temperature. The control unit 103 may be configured to increase the heat dissipation power of the heat dissipation apparatus in response to the temperature being greater than an upper limit of a preset temperature range. The control unit 103 may be configured to decrease the heat dissipation power of the heat dissipation apparatus in response to the temperature being less than a lower limit of the preset temperature range.

It should be understood that the upper limit of the preset temperature range may refer to a maximum temperature corresponding to the preset temperature range, and the lower limit of the preset temperature range may refer to a maximum temperature corresponding to the preset temperature range. For example, in response to the preset temperature range being greater than or equal to T1 and less than or equal to T2, the T1 may be the lower limit of the preset temperature range and T2 may be the upper limit of the preset temperature range.

That is, in the charging process, the electronic device 200 may report the temperature to the charging device 300 via the first data line D+ and the second data line D-, such that the charging device 300 may determine the current charging parameter based on the temperature and may charge the battery based on the current charging parameter. In this case, the control unit 103 may obtain the temperature of the electronic device 200 while being charged by monitoring the first data line D+ and the second data line D-. Further, the control unit 103 may adjust the heat dissipation power of the heat dissipation assembly 101 based on the temperature. The temperature may be temperature of the battery.

Specifically, in an application, the control unit 103 may increase or decrease the heat dissipation power of the heat dissipation assembly 101 based on the temperature of the battery and the preset temperature range, such that the temperature of the battery may be maintained in the preset temperature range, the heat dissipation performance of the heat dissipation apparatus may be controlled intelligently, and the heat dissipation effect may be improved effectively.

According to another embodiment of the present disclosure, the state information of the electronic device may include the charging parameter. The control unit 103 may be configured to determine a charging power level corresponding to the charging parameter and to adjust the heat dissipation power of the heat dissipation apparatus based on the corresponding charging power level.

That is, in the charging process, the electronic device 200 may report the charging parameter to the charging device 300 through the communication of the first data line D+ and the second data line D-, such that the charging device 300 may charge the battery based on the charging parameter. At the same time, the control unit 103 may obtain the charging parameter of the electronic device 200 while being charged by monitoring the first data line D+ and the second data line D-. Further, the control unit 103 may adjust the heat dissipation power of the heat dissipation assembly 101 based on the charging parameter. The charging parameter may include a parameter for indicating the charging power, such as a charging current, a charging voltage, and the like.

In detail, in an application, the control unit 103 may determine the heat dissipation power of the heat dissipation assembly 101 based on the charging parameter of the electronic device 300 in the charging process through predetermined parameter correspondence. The parameter correspondence may be configured to indicate correspondence between the charging current and the heat dissipation power or the correspondence between the charging voltage and the heat dissipation power.

In some embodiments of the present disclosure, the control module 103 may monitor the information sent by at least one of the electronic device 200 and the charging device 300 to determine whether to turn on the heat dissipation assembly 101. It should be understood that the heat dissipation assembly 101 may be turned on based on the information sent by the electronic device 200 or the information sent by the charging device 300, such that the heat dissipation apparatus 100 may be turned on automatically.

According to an embodiment of the present disclosure, the control unit 103 may obtain instruction information sent by the electronic device 200 or the charging device 300 through the connection assembly 101 and may turn on the heat dissipation assembly 101 based on the instruction information.

For example, the instruction information may be a turn-on instruction that instructs the heat dissipation apparatus to turn on the heat dissipation assembly. In detail, when the electronic device 200 or the charging device 300 enters a high-power charging mode in which the heat dissipation apparatus assists in dissipating heat, the electronic device 200 or the charging device 300 may send the turn-on instruction to the data line in the connection assembly 101. The control unit 103 may determine to turn on the heat dissipation assembly 101 in response to the control unit 103 monitoring the turn-on instruction via the data line in the connection assembly 101.

As another example, the instruction information may be a feedback instruction that identifies the heat dissipation apparatus 100. In detail, after the electronic device 200 or the charging device 300 identifies the heat dissipation apparatus 100, the electronic device 200 or the charging device 300 may send the feedback instruction via the data line of the connection assembly 101. The control unit 103 may determine to turn on the heat dissipation assembly 101 in response to the control unit 103 monitoring the feedback instruction via the data line of the connection assembly 101.

According to another embodiment of the present disclosure, the control unit 103 may obtain the information sent by at least one of the electronic device 200 and the charging device 300 through the connection assembly 101 to determine a charging mode. Further, the control unit 103 may turn on the heat dissipation assembly 101 in response to the charging mode being determined as a preset charging mode.

It should be noted that the preset charging mode may be the high-power charging mode. For example, in the high-power charging mode, the charging power of the electronic device 300 may be greater than 50W. A charging power of greater than 50 W may require the heat dissipation assembly 102 to dissipate heat from the electronic device that is being charged.

It should be understood that the electronic device 200 may send information including the charging mode to the charging device 300 through the connection assembly 101. The control unit 103 in the heat dissipation apparatus 100 may obtain the information including the charging mode by monitoring the data line in the connection assembly 101. After obtaining the information including the charging mode, the control unit 103 may determine whether the charging mode is the preset charging mode. In response to the charging mode being the preset charging mode, it may be determined that the heat dissipation assembly 101 is to be turned on. Alternatively, the charging device 300 may send information including the charging mode to the electronic device 200 via the connection assembly 101. The control unit 103 of the heat dissipation apparatus 100 may obtain the information including the charging mode by monitoring the data line in the connection assembly 101. After obtaining the information including the charging mode, the control unit 103 may determine whether the charging mode is the preset charging mode. In response to the charging mode being the preset charging mode, it may be determined that the heat dissipation assembly 101 is to be turned on.

In some embodiments, while the charging device is charging the electronic device, the control unit 103 may monitor the information sent by at least one of the electronic device 200 and the charging device 300 via the connection assembly 101 to determine whether the charging mode is switched from the preset charging mode to a non-preset charging mode. In response to the charging mode being switched from the preset charging mode to the non-preset charging mode, the heat dissipation assembly 102 may be turned off. In this way, in response to the charging mode being switched in the charging process, the heat dissipation apparatus may be turned off.

According to the present disclosure, the heat dissipation apparatus is provided. When the first connection port is connected to the charging device, and the second connection port is connected to the electronic device, the control unit may obtain the information sent by at least one of the electronic device and the charging device through the connection assembly, and may control the heat dissipation process of the heat dissipation assembly based on the information sent by at least one of the electronic device and the charging device. In this way, the heat dissipation performance of the heat dissipation apparatus may be adjusted in real time by monitoring at least one of the electronic device and the charging device, the heat dissipation effect may be improved effectively. By taking the heat dissipation apparatus to dissipate heat from the electronic device, the charging power of the electronic device may be improved, and the charging rate and charging efficiency may be improved.

Based on the heat dissipation apparatus of the above embodiments, the embodiments of the present disclosure may further provide a charging system.

FIG. 3 is a block diagram of a charging system according to an embodiment of the present disclosure. As shown in FIG. 3, the charging system may include: an electronic device 200; a charging device 300; the heat dissipation apparatus 100 as described in the embodiments of the first aspect. The heat dissipation apparatus 100 may be connected to the charging device 300, and the heat dissipation apparatus 100 may also be connected to the electronic device 200.

According to the charging system provided in the present embodiment, the heat dissipation performance of the heat dissipation apparatus may be adjusted in real time by monitoring at least one of the electronic device and the charging device, the heat dissipation effect may be improved effectively. By taking the heat dissipation apparatus to dissipate heat from the electronic device, the charging power of the electronic device may be improved, and the charging rate and charging efficiency may be improved.

Based on the heat dissipation apparatus of the above embodiments, the present disclosure further provides a control method of the heat dissipation apparatus.

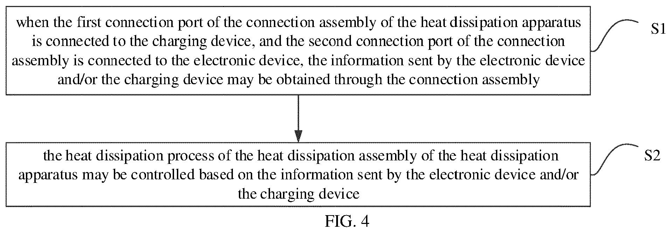

FIG. 4 is a flow chart of the control method of the heat dissipation apparatus according to an embodiment of the present disclosure. As shown in FIG. 4, the control method of the heat dissipation apparatus of the present embodiment may include the following operations.

In an operation S1, when the first connection port of the connection assembly of the heat dissipation apparatus is connected to the charging device, and the second connection port of the connection assembly is connected to the electronic device, the information sent by at least one of the electronic device and the charging device are obtained through the connection assembly.

In an operation S2, the heat dissipation process of the heat dissipation assembly of the heat dissipation apparatus are controlled based on the information sent by at least one of the electronic device and the charging device.

According to an embodiment of the present disclosure, the information sent by at least one of the electronic device and the charging device may include the state information of the electronic device. Controlling the heat dissipation assembly of the heat dissipation apparatus based on the information sent by at least one of the electronic device and the charging device may include: adjusting the heat dissipation power of the heat dissipation assembly based on the state information of the electronic device.

According to an embodiment of the present disclosure, the state information of the electronic device may include the temperature. Adjusting the heat dissipation power of the heat dissipation assembly based on the state information of the electronic device may include: increasing the heat dissipation power of the heat dissipation apparatus when the temperature is greater than the upper limit of the preset temperature range; and decreasing the heat dissipation power of the heat dissipation apparatus when the temperature is less than the lower limit of the preset temperature range.

According to an embodiment of the present disclosure, the state information of the electronic device may include the charging parameter. Adjusting the heat dissipation power of the heat dissipation assembly based on the state information of the electronic device may include: determining the charging power level corresponding to the charging parameter; and adjusting the heat dissipation power of the heat dissipation assembly based on the corresponding charging power level.

According to an embodiment of the present disclosure, the control method of the heat dissipation apparatus may further include: obtaining the instruction information sent by the electronic device or the charging device through the connection assembly; and turning on the heat dissipation assembly based on the instruction information.

According to an embodiment of the present disclosure, the control method of the heat dissipation apparatus may further include: obtaining the information sent by at least one of the electronic device and the charging device through the connection assembly to determine the charging mode; and turning on the heat dissipation assembly when the charging mode is determined as the preset charging mode.

It should be noted that the above explanation and description of the embodiments of the heat dissipation apparatus may also be applicable to the control method of the heat dissipation apparatus in the present embodiment and will not be repeatedly described hereinafter.

According to the control method of the heat dissipation apparatus in the embodiments of the present application, when the first connection port is connected to the charging device, and the second connection port is connected to the electronic device, the information sent by at least one of the electronic device and the charging device may be obtained through the connection assembly, and the heat dissipation process of the heat dissipation assembly may be controlled based on the information sent by at least one of the electronic device and the charging device. In this way, the heat dissipation performance of the heat dissipation apparatus may be adjusted in real time by monitoring at least one of the electronic device and the charging device. The heat dissipation effect may be improved effectively. The heat dissipation apparatus may dissipate heat from the electronic device, such that the charging power of the electronic device may be improved, and the charging rate and the charging efficiency may be improved.

In the description of the present disclosure, terms of "an embodiment", "some embodiments", "examples", "specific examples", or "some examples" may indicate that the specific features, structures, materials, or characteristics described by referring to the embodiments or examples are included in at least one embodiment or example of the present disclosure. In the present description, the exemplary expression of the above terms does not have to be directed to a same embodiment or example. Further, the specific features, structures, materials, or characteristics may be combined in a suitable manner in any one or more embodiments or examples. In addition, without contradicting each other, any skilled person in the art may combine and incorporate various embodiments or examples and the features of the various embodiments or examples.

In addition, terms of "first" and "second" may be used for descriptive purposes only and should not be interpreted as indicating or implying relative importance or implicitly specifying the number of technical features. Therefore, the features defined by the "first" and "second" may explicitly or implicitly include at least one such feature. In the present description, the "plurality" means at least two, such as two, three, and so on, unless otherwise specifically defined.

Any ordinary skilled person in the art should realize that the units and algorithmic operations of the various examples described in the embodiments of the present disclosure may be implemented in electronic hardware, or a combination of computer software and electronic hardware. Whether these functions are performed in hardware or software depends on the particular application and design constraints of the technical solution. The skilled person may perform different methods to implement the described functions for each particular application, and such implementation should not be considered beyond the scope of the present invention.

It will be clear to those skilled person in the art that, in order to provide convenient and concise description, specific working processes of the system, the device and the unit described in the above may be referred to the corresponding processes in the preceding method embodiments and will not be repeatedly described hereinafter.

In the various embodiments provided in the present disclosure, it should be understood that the disclosed system, device and method, may be implemented by other means. For example, the above embodiments of devices are merely exemplary. For example, the units may be divided based on logical functions. Practically, the units may be divided by other means. For example, multiple units or components may be combined or integrated into another system. Some features may be omitted or not implemented. Further, the shown or discussed mutual coupling or direct coupling or communicative connection may be indirect coupling or communicative connection through some interfaces, apparatuses or units, which may be electrical, mechanical or in other forms.

The units illustrated as separate components may or may not be physically separated. The components displayed as units may or may not be physical units. That is, the components may be located in one place or may be distributed to a plurality of network units. Some or all of these units may be selected based on practical needs to achieve the purpose of the present disclosure.

In addition, each functional unit in each embodiment of the present disclosure may be integrated in a single processing unit or may be physically present separately. Alternatively, two or more units may be integrated in a single unit.

When the functions are implemented in the form of a software functional unit and sold or used as an independent product, the software functional unit may be stored in a computer readable storage medium. Based on this understanding, the technical solution of the present disclosure, or the part of the technical solution that essentially contributes to the prior art, may be embodied in the form of a software product. The software product may be stored in a storage medium and may include a number of instructions to enable a computer device (which may be a personal computer, a server, or a network device, and the like) to perform all or some of the operations of the method described in various embodiments of the present disclosure. The aforementioned storage medium may include: a USB disk, a portable hard disk, a Read-Only Memory (ROM), a Random Access Memory (RAM), a magnetic disk or an optical disk, and other media that can store program codes.

The above description only shows the implementations of the present disclosure, but the scope of the present disclosure is not limited thereto. Therefore, the scope of the present disclosure shall be subject to the scope of the claims.

## Claims

1. A heat dissipation apparatus, comprising:
a connection assembly (101), having a first connection port and a second connection port;
a heat dissipation assembly (102); and
a control unit (103), connected to the connection assembly (101) and the heat dissipation assembly (102), wherein
the control unit (103) is configured to obtain information sent by an electronic device (200) and a charging device (300) through the connection assembly (101) in response to the first connection port being connected to the charging device (300) and the second connection port being connected to the electronic device (200); and
the control unit (103) is configured to control a heat dissipation process of the heat dissipation assembly (102) based on the information sent by the electronic device (200) and the charging device (300).

2. The heat dissipation apparatus according to claim 1, wherein the control unit (103) is configured to obtain state information of the electronic device (200) through the connection assembly (101) and to adjust a heat dissipation power of the heat dissipation assembly (102) based on the state information of the electronic device (200).

3. The heat dissipation apparatus according to claim 2, wherein
the state information of the electronic device (200) comprises temperature;
the control unit (103) is configured to increase the heat dissipation power of the heat dissipation apparatus in response to the temperature being greater than an upper limit of a preset temperature range; and
the control unit (103) is configured to decrease the heat dissipation power of the heat dissipation apparatus in response to the temperature being less than a lower limit of the preset temperature range.

4. The heat dissipation apparatus according to claim 2, wherein
the state information of the electronic device (200) comprises a charging parameter; and
the control unit (103) is configured to determine a charging power level corresponding to the charging parameter and to adjust the heat dissipation power of the heat dissipation apparatus based on the corresponding charging power level.

5. The heat dissipation apparatus according to any one of claims 1 to 4, wherein the control unit (103) is configured to obtain instruction information sent by the electronic device (200) or the charging device (300) through the connection assembly (101), and configured to turn on the dissipation assembly based on the instruction information.

6. The heat dissipation apparatus according to any one of claims 1 to 4, wherein the control unit (103) is configured to obtain the information sent by at least one of the electronic device (200) and the charging device (300) through the connection assembly (101) to determine a charging mode, and configured to turn on the heat dissipation assembly (102) in response to the charging mode being determined to be a preset charging mode.

7. The heat dissipation apparatus according to claim 6, wherein
while the charging device (300) is charging the electronic device (200), the control unit (103) is configured to determine whether the charging mode is switched from the preset charging mode to a non-preset charging mode; and
the control unit (103) is configured to turn off the heat dissipation assembly (102) in response to the charging mode being switched from the preset charging mode to the non-preset charging mode.

8. The heat dissipation apparatus according to any one of claims 1 to 7, wherein the connection assembly (101) comprises a data line, and the charging device (300) communicates with the electronic device (200) via the data line.

9. The heat dissipation apparatus according to claim 8, wherein
an end of the data cable is connected the first connection port, and the other end of the data line is connected to the second connection port;
when the first connection port is connected to the charging device (300), and the second connection port is connected to the electronic device (200), the data line is configured to transmit the information sent by the electronic device (200) to the charging device (300) and transmit the information sent by the charging device (300) to the electronic device (200); and
the control unit (103) is configured to obtain the information sent by at least one of the electronic device (200) and by the charging device (300) via the data line.

10. The heat dissipation apparatus according to any one of claims 1 to 9, wherein the connection assembly (101) comprises a power line, and the charging device (300) is configured to charge the electronic device (200) via the power line.

11. The heat dissipation apparatus according to claim 10, wherein
an end of the power line is connected to the first connection port, the other end of the power cord is connected to the second connection port; and
when the first connection port is connected to the charging device (300), and the second connection port is connected to the electronic device (200), the power line is configured to deliver electrical energy output from the charging device (300) to the electronic device (200) to charge the electronic device (200).

12. The heat dissipation apparatus according to claim 10 or 11, wherein the power line is further connected to a power supply end of the control unit (103) to supply power for the control unit (103).

13. A charging system, comprising:
an electronic device (200);
a charging device (300); and
a heat dissipation apparatus (100) according to any one of claims 1-12, wherein the heat dissipation apparatus (100) is connected to the charging device (300), and further connected to the electronic device (200).

14. A control method for a heat dissipation apparatus, the heat dissipation apparatus configured to connect to a charging device and an electronic device, the method comprising:
obtaining (S1), by the heat dissipation apparatus, information sent by the electronic device and the charging device through a connection assembly, when a first connection port of the connection assembly of the heat dissipation apparatus is connected to the charging device, and a second connection port of the connection assembly is connected to the electronic device; and
controlling (S2) a heat dissipation process of the heat dissipation assembly of the heat dissipation apparatus based on the information sent by the electronic device and the charging device.

15. The control method according to claim 14, wherein the information sent by the electronic device and/or the charging device comprises state information of the electronic device, and the controlling (S2) a heat dissipation process of the heat dissipation assembly of the heat dissipation apparatus based on the information sent by the electronic device and/or the charging device, comprises:
adjusting a heat dissipation power of the heat dissipation assembly based on the state information of the electronic device.

## Patentansprüche

1. Wärmeableitungsvorrichtung, umfassend:
eine Verbindungsanordnung (101) mit einem ersten Verbindungsanschluss und einem zweiten Verbindungsanschluss;
eine Wärmeableitungsanordnung (102); und
eine Steuereinheit (103), die mit der Verbindungsanordnung (101) und der Wärmeableitungsanordnung (102) verbunden ist, wobei
die Steuereinheit (103) dazu konfiguriert ist, durch ein elektronisches Gerät (200) und ein Ladegerät (300) über die Verbindungsanordnung (101) gesendete Informationen in Reaktion darauf zu erhalten, dass der erste Verbindungsanschluss mit dem Ladegerät (300) verbunden ist und der zweite Verbindungsanschluss mit dem elektronischen Gerät (200) verbunden ist; und
die Steuereinheit (103) dazu konfiguriert ist, einen Wärmeableitungsprozess der Wärmeableitungsanordnung (102) basierend auf den durch das elektronische Gerät (200) und das Ladegerät (300) gesendeten Informationen zu steuern.

2. Wärmeableitungsvorrichtung nach Anspruch 1, wobei die Steuereinheit (103) dazu konfiguriert ist, Zustandsinformationen des elektronischen Geräts (200) über die Verbindungsanordnung (101) zu erhalten und eine Wärmeableitungsleistung der Wärmeableitungsanordnung (102) basierend auf den Zustandsinformationen des elektronischen Geräts (200) anzupassen.

3. Wärmeableitungsvorrichtung nach Anspruch 2, wobei
die Zustandsinformationen des elektronischen Geräts (200) eine Temperatur umfassen;
die Steuereinheit (103) dazu konfiguriert ist, die Wärmeableitungsleistung der Wärmeableitungsvorrichtung in Reaktion darauf zu erhöhen, dass die Temperatur größer als eine Obergrenze eines voreingestellten Temperaturbereichs ist; und
die Steuereinheit (103) dazu konfiguriert ist, die Wärmeableitungsleistung der Wärmeableitungsvorrichtung in Reaktion darauf zu verringern, dass die Temperatur kleiner als eine Untergrenze des voreingestellten Temperaturbereichs ist.

4. Wärmeableitungsvorrichtung nach Anspruch 2, wobei
die Zustandsinformationen des elektronischen Geräts (200) einen Ladeparameter umfassen; und
die Steuereinheit (103) dazu konfiguriert ist, einen dem Ladeparameter entsprechenden Ladeleistungspegel zu bestimmen und die Wärmeableitungsleistung der Wärmeableitungsvorrichtung basierend auf dem entsprechenden Ladeleistungspegel anzupassen.

5. Wärmeableitungsvorrichtung nach einem der Ansprüche 1 bis 4, wobei die Steuereinheit (103) dazu konfiguriert ist, Anweisungsinformationen zu erhalten, die durch das elektronische Gerät (200) oder das Ladegerät (300) über die Verbindungsanordnung (101) gesendet werden, und dazu konfiguriert ist, die Ableitungsanordnung basierend auf den Anweisungsinformationen einzuschalten.

6. Wärmeableitungsvorrichtung nach einem der Ansprüche 1 bis 4, wobei die Steuereinheit (103) dazu konfiguriert ist, die durch mindestens eines des elektronischen Geräts (200) und des Ladegeräts (300) über die Verbindungsanordnung (101) gesendeten Informationen zu erhalten, um einen Lademodus zu bestimmen, und dazu konfiguriert ist, die Wärmeableitungsanordnung (102) in Reaktion darauf einzuschalten, dass bestimmt wird, dass der Lademodus ein voreingestellter Lademodus ist.

7. Wärmeableitungsvorrichtung nach Anspruch 6, wobei
während das Ladegerät (300) das elektronische Gerät (200) lädt, die Steuereinheit (103) dazu konfiguriert ist, zu bestimmen, ob der Lademodus von dem voreingestellten Lademodus in einen nicht voreingestellten Lademodus umgeschaltet wird; und
die Steuereinheit (103) dazu konfiguriert ist, die Wärmeableitungsanordnung (102) in Reaktion darauf abzuschalten, dass der Lademodus von dem voreingestellten Lademodus in den nicht voreingestellten Lademodus umgeschaltet wird.

8. Wärmeableitungsvorrichtung nach einem der Ansprüche 1 bis 7, wobei die Verbindungsanordnung (101) eine Datenleitung umfasst, und das Ladegerät (300) mit dem elektronischen Gerät (200) via die Datenleitung kommuniziert.

9. Wärmeableitungsvorrichtung nach Anspruch 8, wobei
ein Ende des Datenkabels mit dem ersten Verbindungsanschluss verbunden ist, und das andere Ende der Datenleitung mit dem zweiten Verbindungsanschluss verbunden ist;
wenn der erste Verbindungsanschluss mit dem Ladegerät (300) verbunden ist, und der zweite Verbindungsanschluss mit dem elektronischen Gerät (200) verbunden ist, die Datenleitung dazu konfiguriert ist, die durch das elektronische Gerät (200) gesendeten Informationen an das Ladegerät (300) zu übertragen und die durch das Ladegerät (300) gesendeten Informationen an das elektronische Gerät (200) zu übertragen; und
die Steuereinheit (103) dazu konfiguriert ist, die durch mindestens eines des elektronischen Geräts (200) und durch das Ladegerät (300) gesendeten Informationen via die Datenleitung zu erhalten.

10. Wärmeableitungsvorrichtung nach einem der Ansprüche 1 bis 9, wobei die Verbindungsanordnung (101) eine Leistungsleitung umfasst, und das Ladegerät (300) dazu konfiguriert ist, das elektronische Gerät (200) via die Leistungsleitung zu laden.

11. Wärmeableitungsvorrichtung nach Anspruch 10, wobei
ein Ende der Leistungsleitung mit dem ersten Verbindungsanschluss verbunden ist, das andere Ende des Leistungskabels mit dem zweiten Verbindungsanschluss verbunden ist; und
wenn der erste Verbindungsanschluss mit dem Ladegerät (300) verbunden ist, und der zweite Verbindungsanschluss mit dem elektronischen Gerät (200) verbunden ist, die Leistungsleitung dazu konfiguriert ist, von dem Ladegerät (300) ausgegebene elektrische Energie zu dem elektronischen Gerät (200) zu liefern, um das elektronische Gerät (200) zu laden.

12. Wärmeableitungsvorrichtung nach Anspruch 10 oder 11, wobei die Leistungsleitung ferner mit einem Leistungsversorgungsende der Steuereinheit (103) verbunden ist, um die Steuereinheit (103) mit Leistung zu versorgen.

13. Ladesystem, umfassend:
ein elektronisches Gerät (200);
ein Ladegerät (300); und
eine Wärmeableitungsvorrichtung (100) nach einem der Ansprüche 1-12, wobei die Wärmeableitungsvorrichtung (100) mit dem Ladegerät (300) verbunden ist, und ferner mit dem elektronischen Gerät (200) verbunden ist.

14. Steuerverfahren für eine Wärmeableitungsvorrichtung, wobei die Wärmeableitungsvorrichtung dazu konfiguriert ist, mit einem Ladegerät und einem elektronischen Gerät verbunden zu werden, wobei das Verfahren Folgendes umfasst:
Erhalten (S1), durch die Wärmeableitungsvorrichtung, von durch das elektronische Gerät und das Ladegerät über eine Verbindungsanordnung gesendeten Informationen, wenn ein erster Verbindungsanschluss der Verbindungsanordnung der Wärmeableitungsvorrichtung mit dem Ladegerät verbunden ist, und ein zweiter Verbindungsanschluss der Verbindungsanordnung mit dem elektronischen Gerät verbunden ist; und
Steuern (S2) eines Wärmeableitungsprozesses der Wärmeableitungsanordnung der Wärmeableitungsvorrichtung basierend auf den durch das elektronische Gerät und das Ladegerät gesendeten Informationen.

15. Steuerverfahren nach Anspruch 14, wobei die durch das elektronische Gerät und/oder das Ladegerät gesendeten Informationen Zustandsinformationen des elektronischen Geräts umfassen, und das Steuern (S2) eines Wärmeableitungsprozesses der Wärmeableitungsanordnung der Wärmeableitungsvorrichtung basierend auf den durch das elektronische Gerät und/oder das Ladegerät gesendeten Informationen Folgendes umfasst:
Anpassen einer Wärmeableitungsleistung der Wärmeableitungsanordnung basierend auf den Zustandsinformationen des elektronischen Geräts.

## Revendications

1. Appareil de dissipation de chaleur, comprenant :
un ensemble de connexion (101), ayant un premier port de connexion et un deuxième port de connexion ;
un ensemble de dissipation de chaleur (102) ; et
une unité de commande (103), connectée à l'ensemble de connexion (101) et à l'ensemble de dissipation de chaleur (102),
l'unité de commande (103) étant configurée pour obtenir des informations envoyées par un dispositif électronique (200) et un dispositif de charge (300) via l'ensemble de connexion (101) en réponse à la connexion du premier port de connexion au dispositif de charge (300) et à la connexion du deuxième port de connexion au dispositif électronique (200) ; et
l'unité de commande (103) étant configurée pour commander un processus de dissipation de chaleur de l'ensemble de dissipation de chaleur (102) sur la base des informations envoyées par le dispositif électronique (200) et le dispositif de charge (300).

2. Appareil de dissipation de chaleur selon la revendication 1, l'unité de commande (103) étant configurée pour obtenir des informations d'état du dispositif électronique (200) via l'ensemble de connexion (101) et pour ajuster une puissance de dissipation de chaleur de l'ensemble de dissipation de chaleur (102) sur la base des informations d'état du dispositif électronique (200).

3. Appareil de dissipation de chaleur selon la revendication 2,
les informations d'état du dispositif électronique (200) comprenant une température ;
l'unité de commande (103) étant configurée pour augmenter la puissance de dissipation de chaleur de l'appareil de dissipation de chaleur en réponse au fait que la température est supérieure à une limite supérieure d'une plage de température prédéfinie ; et
l'unité de commande (103) étant configurée pour diminuer la puissance de dissipation de chaleur de l'appareil de dissipation de chaleur en réponse au fait que la température est inférieure à une limite inférieure de la plage de température prédéfinie.

4. Appareil de dissipation de chaleur selon la revendication 2,
les informations d'état du dispositif électronique (200) comprenant un paramètre de charge ; et
l'unité de commande (103) étant configurée pour déterminer un niveau de puissance de charge correspondant au paramètre de charge et pour ajuster la puissance de dissipation de chaleur de l'appareil de dissipation de chaleur sur la base du niveau de puissance de charge correspondant.

5. Appareil de dissipation de chaleur selon l'une quelconque des revendications 1 à 4**,** l'unité de commande (103) étant configurée pour obtenir des informations d'instruction envoyées par le dispositif électronique (200) ou le dispositif de charge (300) via l'ensemble de connexion (101), et configurée pour activer l'ensemble de dissipation sur la base des informations d'instruction.

6. Appareil de dissipation de chaleur selon l'une quelconque des revendications 1 à 4**,** l'unité de commande (103) étant configurée pour obtenir les informations envoyées par le dispositif électronique (200) et/ou le dispositif de charge (300) par l'intermédiaire de l'ensemble de connexion (101) afin de déterminer un mode de charge, et configurée pour activer l'ensemble de dissipation de chaleur (102) en réponse à la détermination que le mode de charge est dans un mode de charge prédéfini.

7. Appareil de dissipation de chaleur selon la revendication 6,
le dispositif de charge (300) chargeant le dispositif électronique (200), l'unité de commande (103) étant configurée pour déterminer si le mode de charge est passé du mode de charge prédéfini à un mode de charge non prédéfini ; et
l'unité de commande (103) étant configurée pour désactiver l'ensemble de dissipation de chaleur (102) en réponse au fait que le mode de charge est passé du mode de charge prédéfini au mode de charge non prédéfini.

8. Appareil de dissipation de chaleur selon l'une quelconque des revendications 1 à 7, l'ensemble de connexion (101) comprenant une ligne de données, et le dispositif de charge (300) communiquant avec le dispositif électronique (200) via la ligne de données.

9. Appareil de dissipation de chaleur selon la revendication 8,
une extrémité du câble de données étant connectée au premier port de connexion, et l'autre extrémité de la ligne de données étant connectée au deuxième port de connexion ;
le premier port de connexion étant connecté au dispositif de charge (300), et le deuxième port de connexion étant connecté au dispositif électronique (200), la ligne de données étant configurée pour transmettre les informations envoyées par le dispositif électronique (200) au dispositif de charge (300) et transmettre les informations envoyées par le dispositif de charge (300) au dispositif électronique (200) ; et
l'unité de commande (103) étant configurée pour obtenir les informations envoyées par le dispositif électronique (200) et/ou le dispositif de charge (300) via la ligne de données.

10. Appareil de dissipation de chaleur selon l'une quelconque des revendications 1 à 9, l'ensemble de connexion (101) comprenant une ligne d'alimentation et le dispositif de charge (300) étant configuré pour charger le dispositif électronique (200) via la ligne d'alimentation.

11. Appareil de dissipation de chaleur selon la revendication 10,
une extrémité de la ligne d'alimentation étant connectée au premier port de connexion, l'autre extrémité du cordon d'alimentation étant connectée au deuxième port de connexion ; et
lorsque le premier port de connexion est connecté au dispositif de charge (300), et que le deuxième port de connexion est connecté au dispositif électronique (200), la ligne d'alimentation étant configurée pour délivrer de l'énergie électrique issue du dispositif de charge (300) au dispositif électronique (200) pour charger le dispositif électronique (200).

12. Appareil de dissipation de chaleur selon la revendication 10 ou 11, la ligne d'alimentation étant en outre connectée à une extrémité d'alimentation électrique de l'unité de commande (103) pour fournir de la puissance à l'unité de commande (103).

13. Système de charge, comprenant :
un dispositif électronique (200) ;
un dispositif de charge (300) ; et
un appareil de dissipation de chaleur (100) selon l'une quelconque des revendications 1 à 12, l'appareil de dissipation de chaleur (100) étant connecté au dispositif de charge (300), et en outre connecté au dispositif électronique (200).

14. Procédé de commande pour un appareil de dissipation de chaleur, l'appareil de dissipation de chaleur étant configuré pour se connecter à un dispositif de charge et à un dispositif électronique, le procédé comprenant :
l'obtention (S1), par l'appareil de dissipation de chaleur, d'informations envoyées par le dispositif électronique et le dispositif de charge par l'intermédiaire d'un ensemble de connexion, lorsqu'un premier port de connexion de l'ensemble de connexion de l'appareil de dissipation de chaleur est connecté au dispositif de charge, et qu'un deuxième port de connexion de l'ensemble de connexion est connecté au dispositif électronique ; et
la commande (S2) d'un processus de dissipation de chaleur de l'ensemble de dissipation de chaleur de l'appareil de dissipation de chaleur sur la base des informations envoyées par le dispositif électronique et le dispositif de charge.

15. Procédé de commande selon la revendication 14, les informations envoyées par le dispositif électronique et/ou le dispositif de charge comprenant des informations d'état du dispositif électronique, et la commande (S2) d'un processus de dissipation de chaleur de l'ensemble de dissipation de chaleur de l'appareil de dissipation de chaleur sur la base des informations envoyées par le dispositif électronique et/ou le dispositif de charge, comprenant :
l'ajustement d'une puissance de dissipation de chaleur de l'ensemble de dissipation de chaleur sur la base des informations d'état du dispositif électronique.
